# EUROPÄISCHE PATENTSCHRIFT

(11) **EP 0 365 697 B1**
(45) Veröffentlichungstag und Bekanntmachung des Hinweises auf die Patenterteilung: **28.07.1993**
(21) Anmeldenummer: 88117774.5
(22) Anmeldetag: 25.10.1988
(51) Int. Cl.: H05B 37/03, B60Q 11/00, G01R 31/02

(54) **Schaltungsanordnung zum Erkennen des Leerlaufs einer mit einem elektronischen Schalter in Reihe liegenden Last**
Circuit for detecting an open circuit composed by a load in series with an electronic switch
Circuit pour détecter la rupture d'un circuit composé d'une charge en série avec un interrupteur électronique

(43) Veröffentlichungstag der Anmeldung: 02.05.1990
(73) Patentinhaber: SIEMENS AKTIENGESELLSCHAFT, 80333 München (DE)
(72) Erfinder: Leipold, Ludwig, Dipl.-Ing., D-8000 München 40 (DE); Sander, Rainald, Dipl.-Phys., D-8000 Mònchen 70 (DE); Tihanyi, Jenö, Dr.-Ing., D-8000 München 70 (DE); Weber, Roland, Dipl.-Ing., D-8000 München 40 (DE)

(56) Entgegenhaltungen:
- DE-A- 2 548 866
- DE-A- 2 748 323
- FR-A- 2 446 047
- FR-A- 2 460 087

## Beschreibung

Die Erfindung bezieht sich auf eine Schaltungsanordnung zum Erkennen des Leerlaufs einer Last, die mit einem elektronischen Leistungsschalter in Reihe geschaltet ist.

Für viele Anwendungszwecke, z. B. in Kraftfahrzeugen, ist es erwünscht, den Ausfall einer Last, z. B. einer Glühlampe für die Fahrzeugbeleuchtung, durch Anzeige am Bedienungsfeld zu erkennen. Da die Last im allgemeinen räumlich vom Bedienungsfeld entfernt ist, scheidet die Überwachung der Spannung an der Last selbst aus, da hierfür zusätzliche Leitungen benötigt würden.

In der FR-A-2 446 047 ist eine Schaltungsanordnung zum Erkennen des Leerlaufs einer Last beschreiben. Der Last ist ein mechanischer Schalter in Reihe geschaltet. Zwischen dem mechanischen Schalter und der Last ist ein niederohmiger Widerstand eingeschaltet. Der Spannungsabfall an diesem Widerstand wird dazu benutzt, den Leerlauf über einen Komparator anzuzeigen.

Zweck der vorliegenden Erfindung ist es, eine Schaltungsanordnung der eingangs erwähnten Gattung anzugeben, mit dem der Leerlauf, d. h. die Unterbrechung einer Last an einem von diesem enfernten Ort ohne zusätzliche Leitungen detektiert werden kann.

Dieses Ziel wird erreicht durch einen Komparator, mit dessen einem Eingang eine Referenzspannungsquelle verbunden ist, an dessen anderem Eingang die am Leistungsschalter abfallende Spannung anliegt und dadurch, daß die Referenzspannung kleiner als die beim Nennstrom am Leistungsschalter abfallende Spannung und größer als die beim Leerlauf am Leistungsschalter abfallende Spannung ist.

Weiterbildungen der Erfindung sind Gegenstand der Unteransprüche. Die Erfindung wird anhand eines Ausführungsbeispiels in Verbindung mit FIG 1 näher erläutert. In den FIG 2 und 3 sind Ausgestaltungen einzelner Komponenten der Schaltungsanordnung gezeigt.

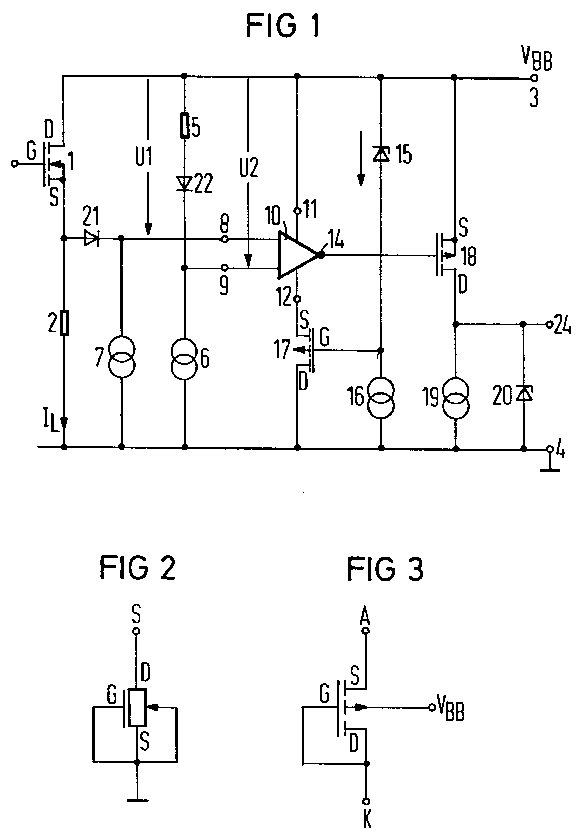

Die Schaltungsanordnung nach FIG 1 enthält einen Leistungs-MOSFET 1, dem sourceseitig eine Last 2 in Reihe geschaltet ist. Die Reihenschaltung aus 1 und 2 liegen an den Klemmen 3, 4, an denen eine Versorgungsspannung V_{BB} anliegt. Der Sourceanschluß des MOSFET 1 ist mit einer Eingangsklemme 8 eines Komparators 10 verbunden. An der anderen Eingangsklemme 9 des Komparators 10 liegt eine Referenzspannung, die aus einer Referenzspannungsquelle gewonnen wird. Diese besteht aus der Reihenschaltung eines Widerstandes 5 und einer Stromquelle 6. Dabei liegt der Widerstand 5 an der Klemme 3 und die Stromquelle an der Klemme 4. Der Verbindungspunkt von 5 und 6 ist mit der Eingangsklemme 9 verbunden. Der Last 2 ist eine Stromquelle 7 parallel geschaltet. Die zwischen dem Sourceanschluß S des MOSFET 1 und der Stromquelle 7 liegende Diode 21 und die zwischen Widerstand 5 und Eingangsklemme 9 liegende Diode 22 sind für die Funktion zunächst nicht wesentlich und werden erst später erläutert. Der Komparator 10 hat zwei Versorgungsspannungs-Klemmen 11, 12. Der Inverter-Ausgang des Komparators 10 trägt die Bezeichnung 14.

Zur Erläuterung der Funktion wird angenommen, daß der MOSFET 1 eingeschaltet ist und die Last 2 von einem Laststrom I_{L} durchflossen ist. Dann liegt an der Eingangsklemme 8 des Komparators 10 eine Spannung U1, die der Drain-Sourcespannung des MOSFET 1 entspricht. An der Eingangsklemme 9 liegt die Referenzspannung U2, die der am Widerstand 5 abfallenden Spannung entspricht. Diese Spannung ist konstant, da die mit dem Widerstand 5 in Reihe geschaltete Stromquelle 6 unabhängig von der Höhe der Versorgungsspannung V_{BB} einen konstanten Strom zieht. Die Referenzspannung U2 ist derart gewählt, daß sie absolut kleiner ist als diejenige Spannung U1, die dann am MOSFET 1 abfällt, wenn die Last 2 nicht unterbrochen ist und daher Nennstrom durch 1 fließt. Die Referenzspannung U2 ist andererseits so eingestellt, daß sie absolut größer ist als diejenige Spannung, die am MOSFET 1 dann abfällt, wenn die Last unterbrochen ist, d. h. im Leerlauffall. Diese beiden am Leistungs-MOSFET 1 abfallenden Spannungen unterscheiden sich und werden daher als Kriterium für einen Lastausfall ausgewertet. Der Lastausfall erzeugt somit am Ausgang 14 des Komparators 10 einen Spannungssprung, die als Anzeige für den Leerlauf der Last 2 ausgewertet wird. Für eine eindeutige Festlegung der im Leerlauffall am MOSFET 1 abfallenden Spannung dient die Stromquelle 7. Die Stromquelle 7 ist derart dimensioniert, daß ihr Strom wesentlich kleiner als der Laststrom ist. Er kann beispielsweise 100 bis 1000 mal niedriger als der Laststrom sein.

Für den Fall, daß die Spannung U1 absolut größer als U2 ist, erscheint am Ausgang 14 das Signal H. Wird die Spannung U1 absolut kleiner als die Spannung U2, erscheint das Signal L.

Dieses Signal wird einem MOSFET 18 zugeführt, der sourceseitig mit der Klemme 3 und drainseitig mit einer Stromquelle 19 verbunden ist. Erscheint am Ausgang 14 das Signal L, so wird der MOSFET 18 durchgeschaltet und an der Ausgangsklemme 24 zwischen 18 und 19 liegt damit praktisch die Spannung V_{BB} an. Diese Spannung wird als Signal für Leerlauf verwendet. Diese Spannung kann durch eine zwischen die Klemmen 24 und 4 geschaltete Zenerdiode 20 begrenzt werden.

Das Ausgangssignal des Komparators 10 kann auch auf andere Weise als durch die aus den Komponenten 18, 19 und 20 gebildete Schaltung weiterverarbeitet werden.

Für den Betrieb des Komparators 10 ist eine konstante Spannung erforderlich. Die Konstantspannungsquelle besteht aus einer Zenerdiode 15, der eine Stromquelle 16 in Reihe geschaltet ist. Dabei ist der Katodenanschluß von 15 mit der Klemme 3 und ein Anschluß der Stromquelle 16 mit der Klemme 4 verbunden. Der andere Anschluß der Stromquelle 16 und der Anodenanschluß von 15 ist mit dem Gateanschluß eines n-Kanal MOSFET 17 verbunden, der drainseitig an der Klemme 4 und sourceseitig an der Versorgungsspannungs-Klemme 12 liegt. Da die Spannung an der Zenerdiode 15 konstant ist, ist auch die Gate-Sourcevorspannung des MOSFET 17 und damit die an den Klemmen 11, 12 liegende Versorgungsspannung des Komparators 10 konstant. Die Stromquelle 16 begrenzt den Strom durch die Zenerdiode 15.

Zweckmäßigerweise wird, wie bereits oben erwähnt, zwischen den Widerstand 5 und die Eingangsklemme 9 eine Diode 22 und zwischen den elektronischen Schalter und die Eingangsklemme 8 eine Diode 21 eingefügt. Diese erhöhen jeweils das Potential an den Eingangsklemmen 8, 9 auf einen für den Komparator 10 geeigneten Wert.

Die Stromquellen können, wie in FIG 2 dargestellt, aus einem n-Kanal-Depletion-MOSFET bestehen, dessen Sourceanschluß S mit seinem Gateanschluß G verbunden ist. Das Substrat (Verbindung mit Pfeil) liegt ebenfalls auf Sourcepotential. Die Dioden 21 und 22 können als MOS-Dioden aufgebaut sein, wie in FIG 3 dargestellt. Die MOS-Diode ist ein p-Kanal-Enhancement-FET, dessen Sourceanschluß die Anode und dessen Drainanschluß die Katode der Diode bildet. Der Gateanschluß G ist mit dem Drainanschluß D verbunden. Das Substrat (Verbindung mit Pfeil) liegt an V_{BB}.

## Patentansprüche

1. Schaltungsanordnung zum Erkennen des Leerlaufs einer Last (2) die mit einem elektronischen Leistungsschalter (1) in Reihe geschaltet ist, mit einen Komparator (10), mit dessen einem Eingang (9) eine Referenzspannungsquelle (5, 6) verbunden ist, **dadurch gekennzeichnet,** daß an dem anderem Eingang (8) des Komparators (10) die am Leistungsschalter (1) abfallende Spannung (U1) anliegt und daß die Referenzspannung (U2) kleiner als die bei Nennstrom am Leistungsschalter abfallende Spannung (U1) und größer als die bei Leerlauf am Leistungsschalter abfallende Spannung (U1) ist.

2. Schaltungsanordnung nach Anspruch 1,
**dadurch gekennzeichnet,** daß die Referenzspannungsquelle einen Widerstand (5) aufweist, dem eine Stromquelle (6) in Reihe geschaltet ist und daß die Referenzspannung am Widerstand abgegriffen wird.

3. Schaltungsanordnung nach Anspruch 2,
**dadurch gekennzeichnet,** daß zwischen Widerstand (5) und Stromquelle (6) eine Diode (22) eingeschaltet ist.

4. Schaltungsanordnung nach Anspruch 1, 2 oder 3,
**dadurch gekennzeichnet,** daß der Last (2) eine Stromquelle (7) parallel geschaltet ist, deren Strom wesentlich geringer als der Nennstrom ist.

5. Schaltungsanordnung nach Anspruch 4,
**dadurch gekennzeichnet,** daß zwischen dem elektronischen Leistungsschalter (1) und der Stromquelle (7) eine Diode (21) eingeschaltet ist.

6. Schaltungsanordnung nach einem der Ansprüche 1 bis 5,
**dadurch gekennzeichnet,** daß die Versorgungsspannung des Komparators (10) von einer Konstantspannungsquelle geliefert wird.

7. Schaltungsanordnung nach Anspruch 6,
**dadurch gekennzeichnet,** daß die Konstantspannungsquelle eine Zenerdiode (15), eine Stromquelle (16) und einen MOSFET (17) aufweist, daß die Anode der Zenerdiode mit der Stromquelle und mit dem Gateanschluß des MOSFET verbunden ist, daß der Sourceanschluß des MOSFET mit der ersten Versorgungsspannungsklemme (12) und der Katodenanschluß mit der zweiten Versorgungsspannungsklemme (11) des Komparators (10) verbunden ist.

## Claims

1. Circuit arrangement for detecting the idle running of a load (2) which is connected in series with an electronic power circuit breaker (1), having a comparator (10) to whose one input (9) a reference-voltage source (5, 6) is connected, characterised in that the voltage (U1) which is dropped on the power circuit breaker (1) is applied to the other input (8) of the comparator (10) and in that the reference voltage (U2) is less than the voltage (U1) which is dropped on the power circuit breaker at rated current and is greater than the voltage (U1) which is dropped on the power circuit breaker during idle running.

2. Circuit arrangement according to Claim 1, characterised in that the reference-voltage source has a resistor (5) in series with which a current source (6) is connected, and in that the reference voltage is picked off on the resistor.

3. Circuit arrangement according to Claim 2, characterised in that a diode is connected between the resistor (5) and the current source (6).

4. Circuit arrangement according to Claim 1, 2 or 3, characterised in that the load (2) is connected in parallel with a current source (7) whose current is significantly less than the rated current.

5. Circuit arrangement according to Claim 4, characterised in that a diode (21) is connected between the electronic power circuit breaker (1) and the current source (7).

6. Circuit arrangement according to one of Claims 1 to 5, characterised in that the supply voltage of the comparator (10) is supplied from a constant-voltage source.

7. Circuit arrangement according to Claim 6, characterised in that the constant-voltage source has a zener diode (15), a current source (16) and a MOSFET (17), in that the anode of the zener diode is connected to the current source and to the gate connection of the MOSFET, in that the source connection of the MOSFET is connected to the first supply-voltage terminal (12) and the cathode connection is connected to the second supply-voltage terminal (11) of the comparator (10).

## Revendications

1. Circuit pour connaître le fonctionnement à vide d'une charge (2), qui est branchée en série avec un disjoncteur électronique (1), comportant un comparateur (10), à une entrée (9) duquel est reliée une source de tension de référence (5,6), caractérisé par le fait que la tension (U1), qui chute dans le disjoncteur (1), est appliquée à l'autre entrée (8) du comparateur (10) et que la tension de référence (U2) est inférieure à la tension (U1), qui, pour un courant nominal, chute dans le disjoncteur, et est supérieure à la tension (U1) qui, lors du fonctionnement à vide, chute dans le disjoncteur.

2. Circuit suivant la revendication 1, caractérisé par le fait que la source de tension de référence comporte une résistance (5), en série avec laquelle est branchée une source de courant (6), et que la tension de référence est prélevée sur la résistance.

3. Circuit suivant la revendication 2, caractérisé par le fait qu'une diode (22) est branchée entre la résistance (5) et la source de courant (6).

4. Circuit suivant la revendication 1, 2 ou 3, caractérisé par le fait qu'en parallèle avec la charge (2) est branchée une source de courant (7), dont le courant est nettement inférieur au courant nominal.

5. Circuit suivant la revendication 4, caractérisé par le fait qu'une diode (21) est branchée entre le disjoncteur électronique (1) et la source de courant (7).

6. Circuit suivant l'une des revendications 1 à 5, caractérisé par le fait que la tension d'alimentation du comparateur (10) est fournie par une source de tension constante.

7. Circuit suivant la revendication 6, caractérisé par le fait que la source de tension constante comporte une diode Zener (15), une source de courant (16) et un transistor MOSFET (17), que l'anode de la diode Zener est reliée à la source de courant et à la borne de grille du transistor MOSFET, que la borne de source du transistor MOSFET est reliée à la première borne (12) de tension d'alimentation et que la borne de cathode est reliée à la seconde borne (11) de tension d'alimentation du comparateur (10).
